# EUROPÄISCHE PATENTSCHRIFT

(11) **EP 2 505 048 B1**
(45) Veröffentlichungstag und Bekanntmachung des Hinweises auf die Patenterteilung: **17.04.2019**
(21) Anmeldenummer: 10778865.5
(22) Anmeldetag: 03.11.2010
(51) Int. Cl.: H05K 3/28, H05K 7/20

(54) **VERFAHREN ZUM HERSTELLEN EINES PLASTISCH VERFORMTEN KUNSTSTOFFKÖRPERS**
METHOD FOR PRODUCING A PLASTICALLY DEFORMED PLASTICS BODY
PROCÉDÉ POUR PRODUIRE UN CORPS EN MATIÈRE PLASTIQUE, DÉFORMÉ PLASTIQUEMENT

(30) Priorität: 25.11.2009 DE 102009055607
(43) Veröffentlichungstag der Anmeldung: 03.10.2012
(73) Patentinhaber: SEW-EURODRIVE GmbH & Co. KG, 76646 Bruchsal (DE)
(72) Erfinder: SCHMIDT, Josef, 76676 Graben-Neudorf (DE); KARST, Andreas, 75239 Eisingen (DE); JUNGINGER, Alexander, 75196 Remchingen-Wilferdingen (DE)
(74) Vertreter: Tüngler, Eberhard
(86) Internationale Anmeldenummer: PCT/EP2010/006690
(87) Internationale Veröffentlichungsnummer: WO 2011/063886

(56) Entgegenhaltungen:
- EP-A2- 0 415 527
- FR-A- 1 148 468
- US-A1- 2005 093 201

## Beschreibung

Die Erfindung betrifft ein Verfahren zum Herstellen eines plastisch verformten Kunststoffkörpers.

Es ist bekannt Wärme erzeugende Bauteile, die auf einer Leiterplatte eines Elektrogeräts bestückt sind, zu entwärmen über einen direkten Kühlkörper-Kontakt oder über eine Luftschicht zwischen Bauelement und Gehäuseteil.

Alternativ ist auch Vergussmasse bekannt, mit der elektronische Schaltungen in einem Gehäuse vergossen werden.

Aus der US 2005/0093201 ist das Abbilden einer bestückten Leiterplatte in einem Gussverfahren in einem Kunststoffkörper bekannt.

Aus der FR 1 148 468 A ist ein Herstellverfahren für die radio-elektrische Montage bekannt.

Aus der EP 0 415 527 A2 ist als nächstliegender Stand der Technik ein Verfahren bekannt, eine Leiterplatte sicher während des Herstellprozesses zu halten, wobei die bestückte Seite der Leiterplatte in ein formbares Material gedrückt wird.

Der Erfindung liegt daher die Aufgabe zugrunde, eine Entwärmung zu verbessern und trotzdem eine lösbare Anordnung einzusetzen.

Erfindungsgemäß wird die Aufgabe bei dem Verfahren nach den in Anspruch 1 angegebenen Merkmalen gelöst.

Von Vorteil ist dabei, dass ein Kunststoffkörper herstellbar ist, der die Kontur der bestückten Leiterplatte aufweist und somit bei Einbau in ein Elektrogerät mit einer so geformten Leiterplatte die Wärme wirksam abführt, weil Luftspalte zwischen Wärme erzeugenden Bauteilen auf der Leiterplatte des Elektrogeräts und dem Kunststoffkörper vermeidbar sind. Der Kunststoffkörper ist daher lösbar und wiederverwendbar in einem Elektrogerät zur Entwärmung einer Leiterplatte mit Bauteilen einsetzbar. Ein Vergießen ist nicht notwendig. Als Werkzeug wird in einfacher Weise eine Leiterplatte genommen, die baugleich ist zur Leiterplatte eines Elektrogeräts, welche wiederum entwärmt werden soll mit dem Werkstück, also dem ausgeformten Kunststoffkörper.

Erfindungsgemäß wird im ersten Schritt auch der Kunststoffkörper erwärmt, insbesondere auf eine Temperatur unterhalb derjenigen kritischen Temperatur, ab deren Überschreiten das Material des Kunststoffkörpers plastisch verformbar ist. Von Vorteil ist dabei, dass die Leiterplatte keine sehr große Wärmemenge beim Aufheizen speichern muss, da nur geringe Wärmemengen zum Überschreiten der kritischen Temperatur und zum ausführen der plastischen Verformung notwendig sind.

Erfindungsgemäß wird im ersten Schritt die Leiterplatte samt deren bestückten Bauteilen auf eine Temperatur erwärmt oberhalb derjenigen kritischen Temperatur, ab deren Überschreiten das Material des Kunststoffkörpers plastisch verformbar ist. Von Vorteil ist dabei, dass als Werkzeug eine zur im später hergestellten Gerät eingesetzte, zu entwärmenden Leiterplatte baugleiche Leiterplatte verwendet wird. Somit ist bei einer Fertigung nur kleiner Stückzahlen, beispielsweise 10 bis 100 Stück, ein Abform-Werkzeug in sehr kostengünstiger Weise und schnell herstellbar, indem ein Exemplar der zu fertigenden Leiterplatten als Werkzeug selbst verwendet wird. Die Funktion der Bauteile dieser als Werkzeug verwendeten Leiterplatte ist allerdings nicht mehr gewährleistbar.

Bei einer vorteilhaften Ausgestaltung wird im zweiten Schritt die Leiterplatte derart tief und derart langandauernd in die Urform des Kunststoffkörper hineinpositioniert, dass im Wesentlichen ein Abdruck und/oder ein Negativabbild der Oberflächenkontur der Leiterplatte samt der auf der dem Kunststoffkörper zugewandten Seite der Leiterplatte bestückten Bauteilen im Kunststoffkörper erzeugt ist mittels thermo-plastischem Verformen von zumindest Teilbereichen des Kunststoffkörpers. Von Vorteil ist dabei, dass ein schnell und einfach verformbarer Kunststoff verwendbar ist.

Bei einer vorteilhaften Ausgestaltung ist der Kunststoffkörper aus Schaumstoff ausgeführt und/oder aus thermoplastischem Material ausgeführt. Von Vorteil ist dabei, dass die Poren an der erwärmten Oberfläche sich verdichten oder sozusagen fast eingebrannt werden, wodurch hier Lufteinschlüsse vermindert werden und im späteren Elektrogerät der Kunststoffkörper möglichst flächig und direkt am jeweiligen Wärme erzeugenden Bauteil anliegt, also möglichst wenig Lufteinschlüsse im Kontaktbereich auftreten.

Bei einer vorteilhaften Ausgestaltung ist die spezifische Wärmeleitfähigkeit größer als 0,03 W/Km oder größer als 0,5 W/Km. Von Vorteil ist dabei, dass eine gute Wärmeableitung erzielbar ist vom Bauteil des Elektrogeräts weg zu einem Gehäuseteil oder Kühlkörper hin. Bei einer Anordnung zum Kühlen von Wärme erzeugenden Bauteilen, die auf einer Leiterplatte angeordnet sind, ist ein Kunststoffkörper zwischen einem Gehäuseteil und den wärmeerzeugenden Bauteilen angeordnet, der nach einem vorgenannten Verfahren hergestellt ist,
insbesondere wobei der Kunststoffkörper im elastisch verformt vorgesehen ist, insbesondere zur Verringerung oder Vermeidung von Luftspalten und/oder Luftschichten zwischen den wärmeerzeugenden Bauelementen und dem Gehäuseteil.

Von Vorteil ist dabei, dass ein direkter Wärmeübergang erreichbar ist zwischen Bauteil und Kunststoffkörper. Insbesondere bei elastischem Andrücken verbessert sich der Wärmeübergang weiter.

Die Erfindung wird nun anhand von Abbildungen näher erläutert:

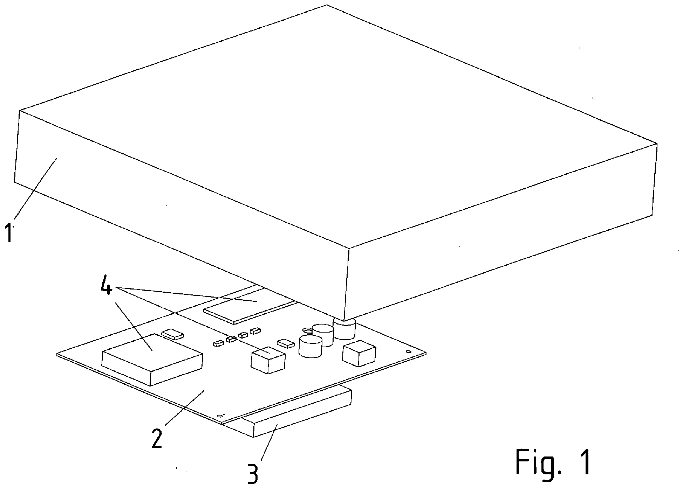

In den Figuren 1 bis 3 ist das erfindungsgemäße Herstellverfahren schematisch skizziert.

Gemäß Figur 1 wird in einem ersten Verfahrensschritt eine Leiterplatte 2 mit auf der Unterseite der Leiterplatte 2 bestückten Bauteilen 3 und auf der Oberseite der Leiterplatte 2 bestückten Bauteilen 4 erhitzt. Dabei übersteigt die Temperatur die für eine Funktion der Bauteile maximal zulässige Temperatur. Die Bauteile (3, 4) sind somit mit hoher Wahrscheinlichkeit in ihrer Funktion geschädigt.

Ein Kunststoffkörper 1 wird bereit gestellt, der ab einer kritischen Temperatur zumindest plastisch verformbar ist.

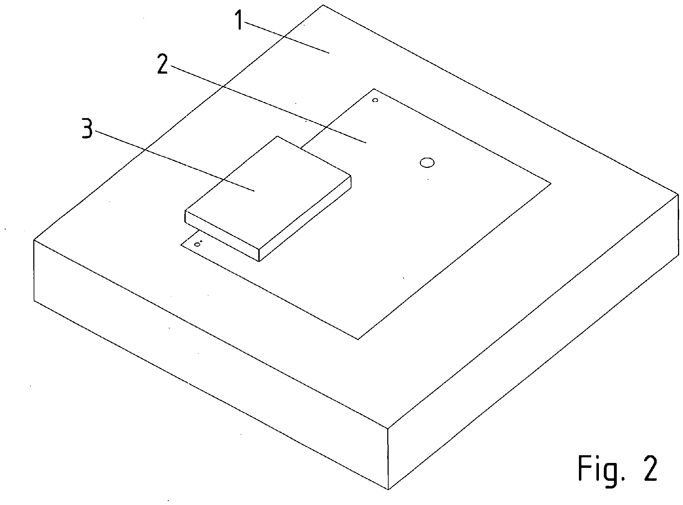

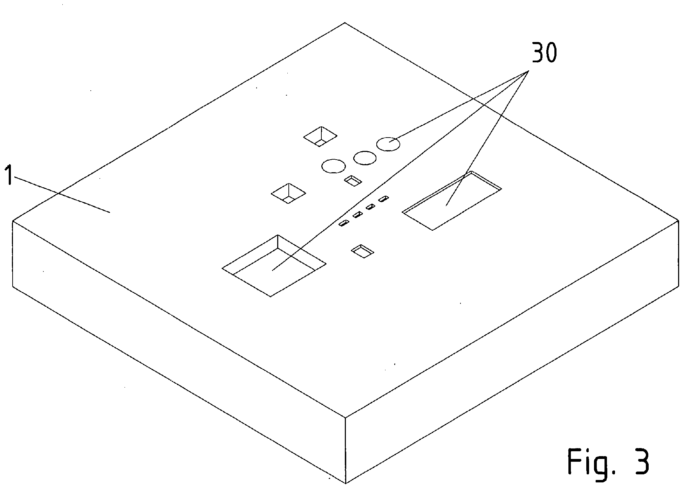

Gemäß Figur 2 wird in einem zweiten Verfahrensschritt die Leiterplatte 2 in Kontakt gebracht mit dem Kunststoffkörper 1. Dabei wird die Leiterplatte 2 derart tief und lang in den Kunststoffkörper eingetaucht, dass - wie in Figur 3 gezeigt - nach Herausnehmen der Leiterplatte 2 der Kunststoffkörper 1 derart plastisch verformt ist, dass 30 ausgeformte Vertiefungen 30 entstehen. Diese entsprechen im Wesentlichen sozusagen dem Negativ der Oberflächenkontur der entsprechenden Seite der Leiterplatte samt bestückten Bauteilen 4. Dieses Negativbild der Leiterplattenkontur bleibt auch nach Abkühlung des Kunststoffkörpers erhalten.

Auf diese geschilderte Weise sind also mit der Leiterplatte 2 als Werkzeug viele abgeformte Kunststoffkörper 1 herstellbar.

Danach erfolgt mit den so abgeformten Kunststoffkörpern 1 eine Herstellung eines Elektrogeräts.

Hierbei wird in ein Gehäuse des Elektrogeräts eine Leiterplatte eingebaut, welche zumindest auf einer ihrer Seiten dieselbe oder eine im Wesentlichen ähnliche Leiterplattenkontur aufweist, wie die Leiterplatte 1 samt Bauteilen 4. Vorzugsweise wird dieselbe Leiterplatte und Bestückung gewählt.

Auf diese Leiterplatte samt Bestückung ist nun einer der ausgeformten Kunststoffkörper aufsetzbar, ohne dass wesentliche Luftspalte zwischen Leiterplatte beziehungsweise Bauteilen 4 der Leiterplatte und dem Kunststoffkörper 2 entstehen.

Somit ist die Wärme von Wärme erzeugenden elektronischen Bauteilen, wie beispielsweise Halbleiterschaltern, Mikrocontrollern, Mikroprozessoren, Widerständen, Induktivitäten oder dergleichen, direkt an den Kunststoffkörper abführbar und der Wärmefluss in diesem aufspreizbar.

Vorzugsweise wird der Kunststoffkörper im Elektrogerät derart angeordnet, dass er zwischen Gehäuse und Leiterplatte elastisch verformt wird und somit mit einem gewissen leichten Anpressdruck an den Wärme erzeugenden Bauteilen anliegt. Somit ist ein noch weiter verbesserter Wärmeübergang erreichbar.

Über den wärmeleitfähigen Kunststoffkörper wird die Wärme dann ans Gehäuse des Elektrogeräts und von dort an die Umgebung geführt. Das Gehäuse ist dabei auch mit Oberflächen-vergrößernden Ausformungen, wie Kühlfingern und/oder Kühlrippen ausführbar und/oder mit Flüssigkeiten, wie Wasser kühlbar.

In einem weiteren erfindungsgemäßen Ausführungsbeispiel wird der Kunststoffkörper im ersten Verfahrensschritt, also vor dem in Kontakt bringen mit der erhitzten Leiterplatte vorgewärmt auf eine Temperatur knapp unterhalb der kritischen Temperatur.

In einem weiteren erfindungsgemäßen Ausführungsbeispiel beträgt die Wärmeleitfähigkeit mehr als 0,03 W/mK oder sogar mehr als 0,5 W/mK. Dabei bedeutet W/mK die Einheit Watt pro Kelvin und Meter.

In einem weiteren erfindungsgemäßen Ausführungsbeispiel wird statt des Kunststoffes ein Schaumstoff verwendet, also ein Kunststoff der, insbesondere bei einem Anschnitt, mit dem bloßen Auge erkennbare Lufteinschlüsse aufweist, wobei diese Lufteinschlüsse einen Volumenanteil von mehr als 10 Prozent betragen.

In einem weiteren erfindungsgemäßen Ausführungsbeispiel wird die Leiterplatte samt bestückten Bauteilen (3, 4) mit einem Lack oder einer anderweitigen Beschichtung versehen, so dass eine gleichmäßigere Verteilung der Temperatur an der Oberfläche erreicht wird.

### Bezugszeichenliste

- 1: Kunststoffkörper
- 2: Leiterplatte
- 3: auf der Unterseite der Leiterplatte 2 bestückte Bauteile
- 4: auf der Oberseite der Leiterplatte 2 bestückte Bauteile
- 30: ausgeformte Vertiefungen

## Patentansprüche

1. Verfahren zum Herstellen eines Elektrogeräts mit einem Kunststoffkörper (1),
wobei in einem ersten Schritt eine Urform des Kunststoffkörpers (1) auf eine Temperatur unterhalb derjenigen kritischen Temperatur erwärmt wird, ab deren Überschreiten das Material des Kunststoffkörpers (1) plastisch verformbar ist und eine erste Leiterplatte (2) samt deren bestückten Bauteilen (4) auf eine Temperatur erwärmt wird oberhalb derjenigen kritischen Temperatur, ab deren Überschreiten das Material des Kunststoffkörpers (1) plastisch verformbar ist,
in einem zweiten Schritt die erste Leiterplatte (2) in die Urform, also den Kunststoffkörper (1), zumindest teilweise hineingedrückt wird, wobei der Kunststoffkörper (1) plastisch verformt wird und ausgeformte Vertiefungen im Kunststoffkörper (1) entstehen,
in einem dritten Schritt die erste Leiterplatte (2) herausgenommen wird und der Kunststoffkörper (1) abgekühlt wird,
wonach dieser plastisch verformte und dann abgekühlte Kunststoffkörper (1) zwischen einem Gehäuseteil des Elektrogeräts und einer zur ersten baugleichen, mit zu den Bauteilen (4) baugleichen, wärmeerzeugenden Bauteilen bestückten Leiterplatte (2) angeordnet wird.

2. Verfahren nach Anspruch 1,
**dadurch gekennzeichnet, dass**
im zweiten Schritt die Leiterplatte (2) derart tief und derart langandauernd in die Urform des Kunststoffkörper (1) hineinpositioniert wird, dass im Wesentlichen ein Abdruck und/oder ein Negativabbild der Oberflächenkontur der Leiterplatte (2) samt der auf der dem Kunststoffkörper (1) zugewandten Seite der Leiterplatte (2) bestückten Bauteilen **(4)** im Kunststoffkörper (1) erzeugt ist mittels thermo-plastischem Verformen von zumindest Teilbereichen des Kunststoffkörpers (1).

3. Verfahren nach mindestens einem der vorangegangenen Ansprüche,
**dadurch gekennzeichnet, dass**
der Kunststoffkörper (1) aus thermoplastischem Material ausgeführt ist.

4. Verfahren nach mindestens einem der vorangegangenen Ansprüche,
**dadurch gekennzeichnet, dass**
die spezifische Wärmeleitfähigkeit **des Kunststoffkörpers (1)** größer ist als 0,03 W/Km oder größer als 0,5 W/Km.

## Claims

1. Method for producing an electrical appliance having a plastics body (1),
wherein, in a first step, an original mould of the plastics body (1) is heated to a temperature below the critical temperature above which the material of the plastics body (1) can be plastically deformed, and a first printed circuit board (2) together with its fitted components (4) is heated to a temperature above the critical temperature above which the material of the plastics body (1) can be plastically deformed,
in a second step, the first printed circuit board (2) is pushed at least in part into the original mould, i.e. the plastics body (1), during which the plastics body (1) is plastically deformed and integrally shaped recesses are produced in the plastics body (1),
in a third step, the first printed circuit board (2) is removed and the plastics body (1) is cooled,
after which said plastically deformed and then cooled plastics body (1) is arranged between a housing part of the electrical appliance and a printed circuit board (2) that is structurally identical to the first board and is fitted with heat-generating components that are structurally identical to the components (4).

2. Method according to claim 1,
**characterised in that**
in the second step, the printed circuit board (2) is positioned in the original mould of the plastics body (1) to such a depth and for such a long time that an impression and/or a negative of the surface contour of the printed circuit board (2) together with the components (4) fitted on the side of the printed circuit board (2) facing the plastics body (1) is substantially produced in the plastics body (1) by means of thermoplastic deformation of at least portions of the plastics body (1).

3. Method according to at least one of the preceding claims,
**characterised in that**
the plastics body (1) is made of thermoplastic material.

4. Method according to at least one of the preceding claims,
**characterised in that**
the specific thermal conductivity of the plastics body (1) is greater than 0.03 W/Km or greater than 0.5 W/Km.

## Revendications

1. Procédé de fabrication d'un appareil électrique muni d'un corps (1) en matière plastique,
dans lequel, au cours d'une première étape, un prototype du corps (1) en matière plastique est chauffé jusqu'à une température en deçà de la température critique à partir du dépassement de laquelle le matériau dudit corps (1) en matière plastique est plastiquement déformable, et une première plaquette imprimée (2) est chauffée, conjointement aux composants (4) garnissant cette dernière, jusqu'à une température au-delà de la température critique à partir du dépassement de laquelle ledit matériau dudit corps (1) en matière plastique est plastiquement déformable,
au cours d'une deuxième étape, la première plaquette imprimée (2) est au moins partiellement enfoncée dans ledit prototype, c'est-à-dire dans le corps (1) en matière plastique, sachant que ledit corps (1) en matière plastique est déformé plastiquement, et qu'il est donné naissance à des creusures dans ledit corps (1) en matière plastique,
au cours d'une troisième étape, ladite première plaquette imprimée (2) est extraite et ledit corps (1) en matière plastique est refroidi,
après quoi ce corps (1) en matière plastique déformé plastiquement, puis refroidi, est interposé entre une partie de boîtier de l'appareil électrique et une plaquette imprimée (2) structurellement identique à la première, et garnie de composants générateurs de chaleur qui sont structurellement identiques auxdits composants (4).

2. Procédé selon la revendication 1,
**caractérisé par le fait que**,
durant la deuxième étape, la plaquette imprimée (2) est mise en place, dans le prototype du corps (1) en matière plastique, à une profondeur et pendant une durée propres à engendrer pour l'essentiel dans ledit corps (1) en matière plastique, par déformation thermoplastique d'au moins des régions partielles dudit corps (1) en matière plastique, une empreinte reproduite et/ou une image en négatif du profil de surface de ladite plaquette imprimée (2), conjointement aux composants (4) garnissant la face de ladite plaquette imprimée (2) qui pointe vers ledit corps (1) en matière plastique.

3. Procédé selon au moins l'une des revendications précédentes,
**caractérisé par le fait que**
le corps (1) en matière plastique est réalisé en un matériau thermoplastique.

4. Procédé selon au moins l'une des revendications précédentes,
**caractérisé par le fait que**
la conductivité thermique spécifique du corps (1) en matière plastique est supérieure à 0,03 W/Km ou supérieure à 0,5 W/Km.
